# EUROPEAN PATENT APPLICATION

(11) **EP 4 632 965 A2**
(43) Date of publication of application: **15.10.2025**
(21) Application number: 25198961.2
(22) Date of filing: 17.05.2021
(51) Int. Cl.: H01R 25/00

(54) **STORAGE DEVICE WITH POWER SUPPLY**

(30) Priority: 18.05.2020 US 202063026515 P; 08.09.2020 US 202063075582 P
(62) Divisional of application: 21809648.5
(71) Applicant: Milwaukee Electric Tool Corporation, Brookfield, WI 53005-2550 (US)
(72) Inventor: SEMON, Catherine K., Milwaukee, 53208 (US); LENTZ, Andrew S., Wauwatosa, 53213 (US); HALVERSON, Michael R., Greenfield, 53220 (US); WACKWITZ, Jeffrey M., Waukesha, 53186 (US)
(74) Representative: Barker Brettell LLP

(57) **Abstract**

Various power units that couple with modular storage units are shown. In one example, a power unit includes a power storage device and one or more power outlet interfaces. One of the surfaces of the power unit includes a coupling mechanism that permits that power unit to couple with modular storage units. In one embodiment, the power unit includes a frame and wheels coupled to the frame to permit the power unit to be more easily transported.

## Description

### CROSS-REFERENCE TO RELATED PATENT APPLICATION

The present application claims the benefit of and priority to U.S. Provisional Application No. 63/026,515, filed on May 18, 2020, and U.S. Provisional Application No. 63/075,582, filed on September 8, 2020, both of which are incorporated herein by reference in their entirety.

### BACKGROUND OF THE INVENTION

The present disclosure relates generally to the field of storage units. The present disclosure relates specifically to a modular, portable, storage unit with a power supply.

Tool storage units are often used to transport tools and tool accessories. Some storage units are designed to incorporate into a modular storage system. Within a modular storage system, different units, devices and/or containers may provide varying functions, such as being adapted to provide a power supply.

### SUMMARY OF THE INVENTION

One embodiment of the invention relates to a power supply unit including a housing, an upper surface of the housing, a first coupler located along the upper surface, a battery, and a power outlet in electrical communication with the battery. The first coupler is configured to couple the upper surface of the power supply unit to a bottom surface of a modular storage unit. In various embodiments, the power supply includes a storage compartment defined at least in part by the housing.

Another embodiment of the invention relates to a power supply unit including a housing, an upper surface of the housing, a first interface located along the upper surface, a first power outlet configured to provide alternating current (AC) electricity, and a second power outlet configured to provide direct current (DC) electricity. The first interface is configured to couple the upper surface of the power supply unit to a bottom surface of a modular storage unit.

Another embodiment of the invention relates to a power supply unit assembly including a power supply unit and a power tool battery charger. The power supply unit includes a housing, an upper surface of the housing, a battery, a plurality of coupling components located along the upper surface, and a mount configured to couple to a power tool battery charger. The plurality of coupling components are configured to couple the upper surface of the power supply unit to a bottom surface of a modular storage unit. The power tool battery charger is physically coupled to the mount and electrically coupled to the battery. The power tool battery charger includes a docking station configured to physically couple to a power tool battery and provide electricity to the power tool battery from the battery.

According to one embodiment, a power device, container or power unit includes a housing, a top surface, a first coupler defined by the top surface, the first coupler engageable with a storage unit. The power unit includes one or more power storage devices, such as batteries, and one or more power outlets. In a specific embodiment the power unit is coupled to a frame and a plurality of wheels are coupled to the frame. In a specific embodiment, the power unit includes a top panel coupled to a housing, the top panel and the housing collectively defining a storage compartment. In a specific embodiment, the power unit includes a display that indicates one or more features about the power storage devices, such as their current charge. In a specific embodiment, a mount is coupled to the power device, and the mount has a battery-charging interface.

Additional features and advantages will be set forth in the detailed description, which follows, and, in part, will be readily apparent to those skilled in the art from the description or recognized by practicing the embodiments as described in the written description included, as well as the appended drawings. It is to be understood that both the foregoing general description and the following detailed description are exemplary.

The accompanying drawings are included to provide further understanding and are incorporated in and constitute a part of this specification. The drawings illustrate one or more embodiments and, together with the description, serve to explain principles and operation of the various embodiments.

### BRIEF DESCRIPTION OF THE DRAWINGS

In order to better understand the subject matter that is disclosed herein and to exemplify how it may be carried out in practice, embodiments will now be described, by way of non-limiting examples only, with reference to the accompanying drawings, in which:
FIG. 1 is a perspective view of a mobile power unit, according to another exemplary embodiment;
FIG. 2 is a perspective view of a mobile power unit, according to another exemplary embodiment;
FIG. 3 is a perspective view of a mobile power unit, according to another exemplary embodiment;
FIG. 4 is a perspective view of a mobile power unit, according to another exemplary embodiment;
FIG. 5 is a perspective view of a mobile power unit, according to another exemplary embodiment;
FIG. 6 is a perspective view of a mobile power unit, according to another exemplary embodiment;
FIG. 7 is a perspective view of a power unit, according to an exemplary embodiment;
FIG. 8 is a perspective view of the mobile power unit of FIG. 7;
FIG. 9 is a perspective view of the mobile power unit of FIG. 7;
FIG. 10 is a schematic view and an image of various power outlets of the mobile power unit of FIG. 7;
FIG. 11 is a perspective view of a mobile power unit, according to an embodiment;
FIG. 12 is a perspective view of the mobile power unit of FIG. 11;
FIG. 13 is a perspective view of the mobile power unit of FIG. 11;
FIG. 14 is a perspective view of the mobile power unit of FIG. 11;
FIG. 15 is a perspective view of the mobile power unit of FIG. 11;
FIG. 16 is a perspective view of the mobile power unit of FIG. 11;
FIG. 17 is a perspective view of the mobile power unit of FIG. 11;
FIG. 18 is a perspective view of the mobile power unit of FIG. 11;
FIG. 19 is a perspective view of the mobile power unit of FIG. 11; and
FIG. 20 is a perspective view of a mobile power unit, according to an exemplary embodiment.

### DETAILED DESCRIPTION

Referring generally to the figures, various embodiments of a power device, container with power and/or power unit are shown. One of the power units is configured to selectively couple and decouple with modular storage units. The power unit includes a power supply and one or more power outlets that are configured to provide electricity to other devices. The top surface of the power unit includes one or more coupling components. The coupling components couple the top surface of the power unit to other devices, containers or units, such as a modular storage unit. In some embodiments, the power unit is mobile, such as via the housing being coupled to a frame with wheels. Applicant has observed that finding a power supply at construction work sites can be problematic. The power unit described herein provides a power supply that integrates with a modular storage unit system, such as the Milwaukee PACKOUT^{®} modular storage unit, providing users the ability to more easily carry a power supply and one or more modular tool storage units to a construction site.

Still referring generally to the figures, various embodiments of a power device, container with power and/or power unit are shown. The power unit includes a power supply and one or more power outlets that are configured to provide electricity to other devices. The power until includes a surface with coupling components that couple the power unit to other devices containers, or units, such as a modular storage unit. In some embodiments, the power unit includes a handle that facilitates carrying both the power unit and another device coupled to the bottom of the power unit, providing users the ability to more easily carry a power supply and one or more modular tool storage units to a construction site.

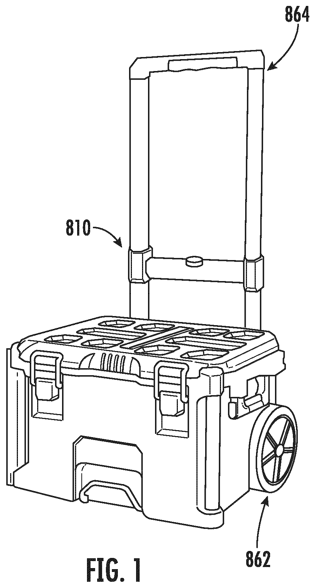

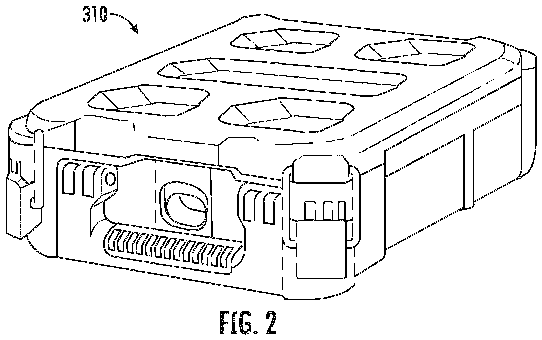

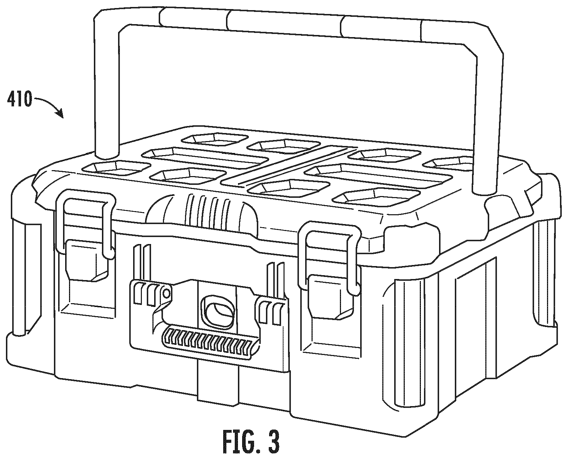

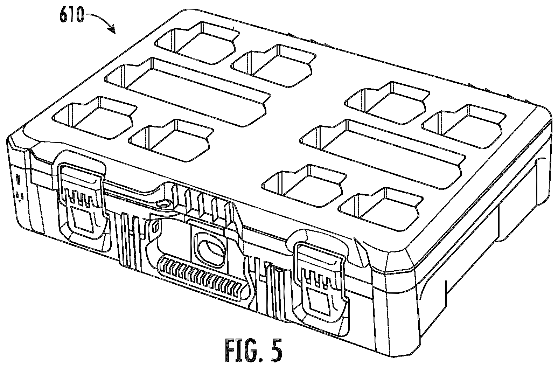

Referring to FIGS. 1-6, various aspects of power units, power devices, and/or containers with power supplies, shown as power units 810, 310, 410, 510, 610, and 710 are shown. Power units 810, 310, 410, 510, 610, and 710 are substantially the same as power unit 10 or power unit 110 except for the differences described herein. In various embodiments, power units 810, 310, 410, 510, 610, and 710 include a power supply and one or more outlets through which other devices can receive power (e.g., electricity) from a battery within the power unit.

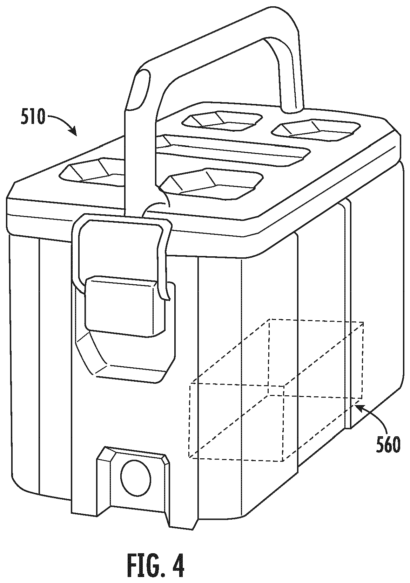

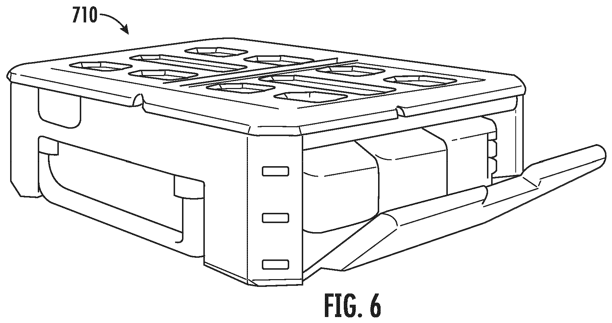

Referring to FIG. 4, power unit 510 includes one or more storage areas, shown as storage compartment 560, which is defined at least in part by the housing of power unit 510. Referring to FIG. 6, power unit 810 includes a plurality of wheels 862 rotatably coupled to the housing, and a handle 864 coupled to the housing.

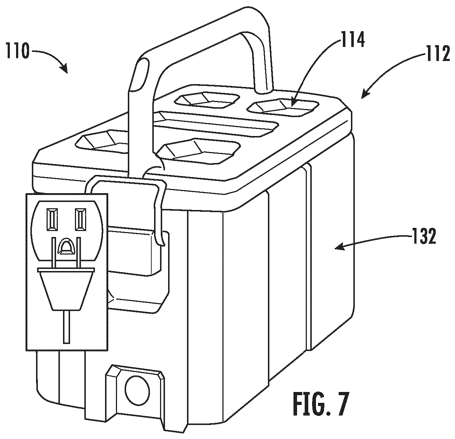

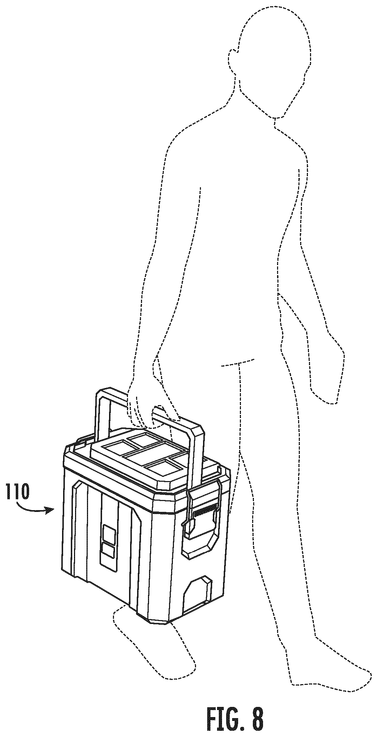

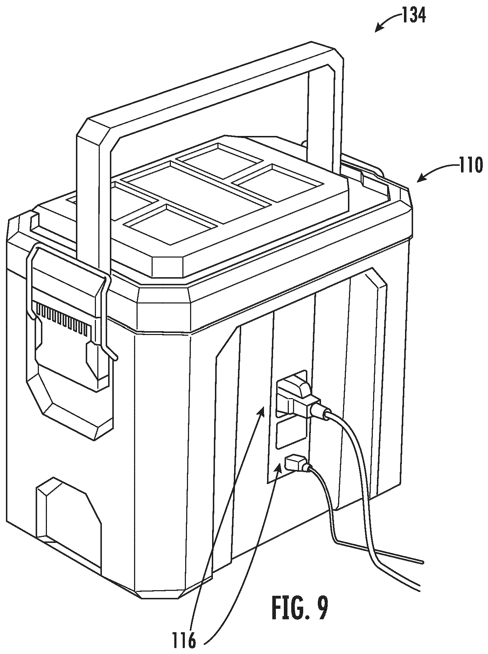

Turning to FIGS. 7-10, various aspects of power unit 110 are shown. Power unit 110 is substantially the same as power unit 10 except for the differences described herein. Top surface 112 includes one or more coupling components 114. In a specific embodiment, the coupling components 114 are compatible with the coupling mechanism(s) described in International Patent Application No. PCT/US2018/044629.

Power unit 110 includes a handle 134 that is rotatably coupled to housing 132. In a specific embodiment, upper surface 112 includes a recess configured to receive handle 134 when handle is rotated against the upper surface 112.

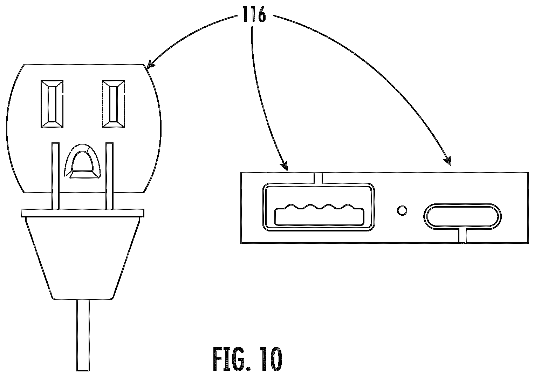

Turning to FIG. 10 in particular, in a specific embodiment, power unit 110 includes one or more power outlets 116. The one or more power outlets 116 include one power outlet 116 with an interface similar to a wall outlet, and/or one power outlet 116 with an interface that is USB-compatible.

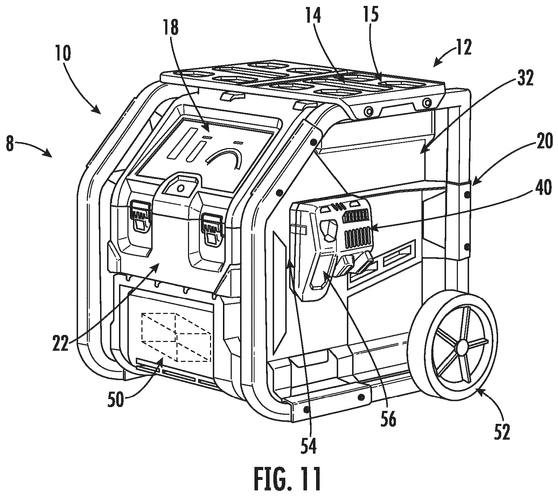

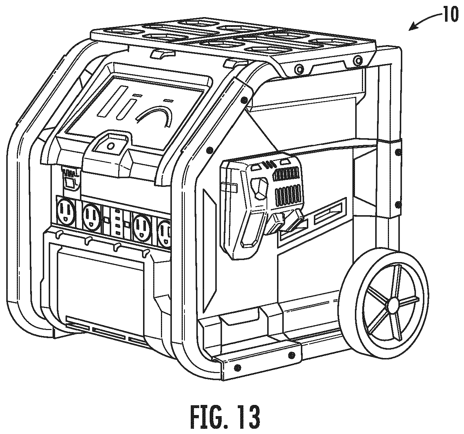

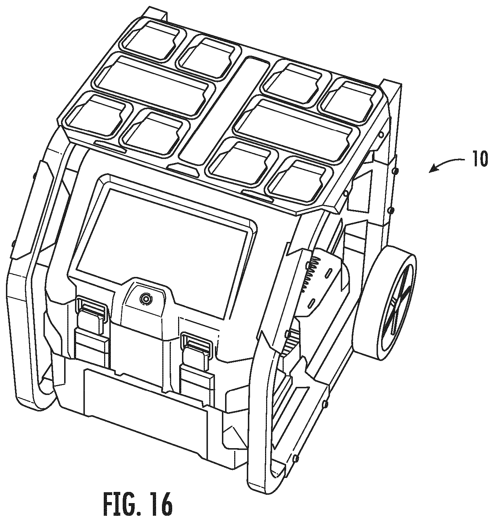

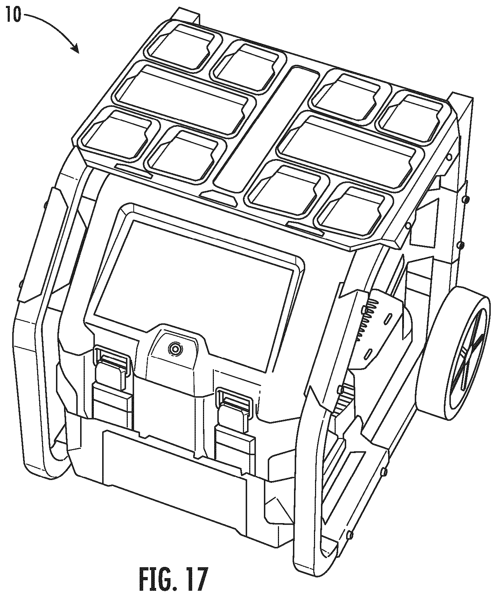

Referring to FIGS. 11-19, various aspects of a device, container or unit with power, such as a power supply unit, shown as power unit 10, are shown. Power unit 10 includes a upper surface 12, which includes coupling components 14 located along upper surface 12. Coupling components includes one or more couplers, shown as first coupler 15. In a specific embodiment, first coupler 15 is located along upper surface 12. In a specific embodiment, coupling components 14 are compatible with the coupling mechanism(s) described in International Patent Application No. PCT/US2018/044629, which is incorporated herein by reference in its entirety. In a specific embodiment, coupling components 14 are configured to couple the upper surface 12 of the power unit 10 to a bottom surface of a modular storage unit. In a specific embodiment, first coupler 15 is a first interface configured to couple the upper surface 12 of the power unit 10 to a bottom surface of a modular storage unit. In a specific embodiment, power supply unit assembly 8 includes a power supply unit 10 and a power tool battery charger 40.

Power unit 10 includes a housing 32 that is coupled to frame 20. A plurality of wheels 52 are rotatably coupled to housing 32 and/or frame 20, permitting power unit 10 to be transported, such as by a user gripping a handle coupled to frame 20 and rolling power unit 10.

Power unit 10 includes a power supply, such as one or more batteries 50. In a specific embodiment, the one or more batteries are stored in a storage compartment defined by housing 32. In another specific embodiment, the housing defines two storage compartments, the first of which houses one or more batteries and the second of which is used to store other objects (e.g., tools, supplies). In a specific embodiment the top panel, which defines upper surface 12, is removable (e.g., via pivoting open) to permit access to the one or more storage compartments within power unit 10. In a specific embodiment, power unit 10 includes a battery 50.

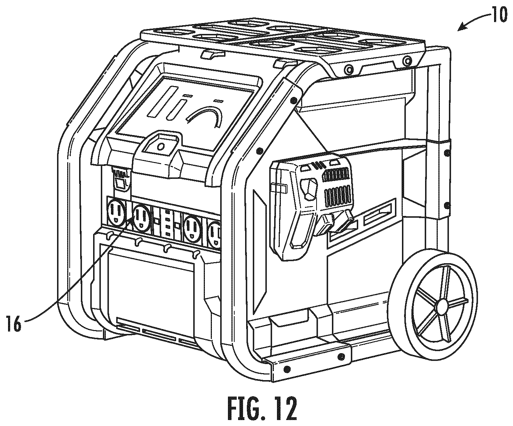

Power unit 10 includes one or more power outlets 16. Cover 22 couples to housing 32 to cover power outlets 16 (best shown in FIG. 11), and can be removed (best shown in FIG. 12) to permit power outlets 16 to be accessed. In a specific embodiment, at least one of power outlets 16 is an interface similar to a wall outlet. In a specific embodiment, at least one of power outlets 16 is a USB-compatible interface. In a specific embodiment, at least one of power outlets 16 is in electrical communication with battery 50. In a specific embodiment, one or more of power outlets 16 is configured to provide alternating current (AC) electricity, and one or more of power outlets 16 is configured to provide direct current (DC) electricity. In a specific embodiment, an outlet configured to provide DC electricity is a USB-compatible outlet.

Power unit 10 includes a display 18, such as on an externally-facing surface of power unit 10. Display 18 indicates various aspects of the power unit 10, including for example the amount of power currently stored and/or being output from power unit 10.

In a specific embodiment, a mount 54 coupled to housing 32 and/or frame 20 of power unit 10. A power supply unit, shown as power tool battery charger 40, is coupled to the power unit 10 via mount 54. Charger 40 is electrically coupled to the one or more batteries 50 and provides power to a battery, such as a power tool battery, that is coupled to charger 40. In a specific embodiment, charger 40 includes a docking station 56 configured to physically couple to a power tool battery and provide electricity to the power tool battery from the battery 50.

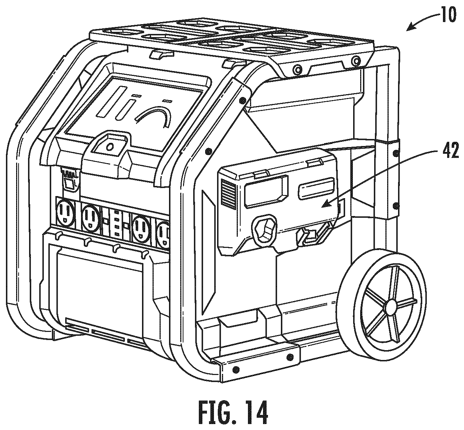

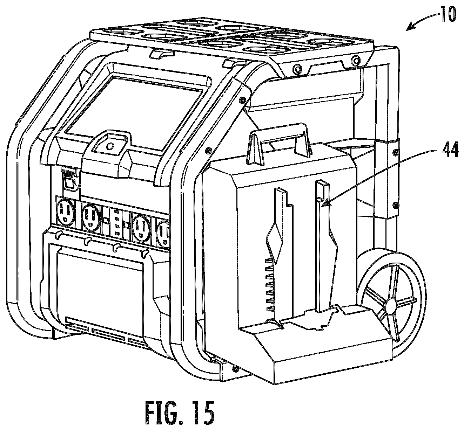

Turning to FIG. 14 and FIG. 15, charger 42 and charger 44, respectively, are detachably coupled to power unit 10. Charger 42 and charger 44 are similar to charger 40 and each other except for the differences discussed herein. Charger 40, charger 42 and charger 44 include different combinations of power outlets for distributing power. For example, charger 40 includes an interface that couples to a battery that is different than one or more outlets provided by charger 42 and/or charger 44. In a specific embodiment of a power unit, a charger is integrated into the power unit frame and electrically coupled to the power supply, such as the one or more batteries.

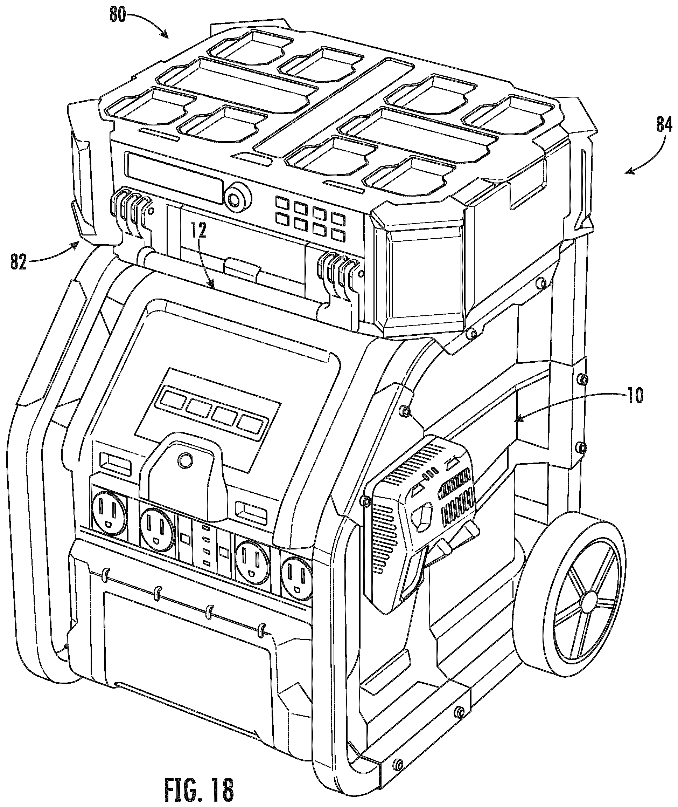

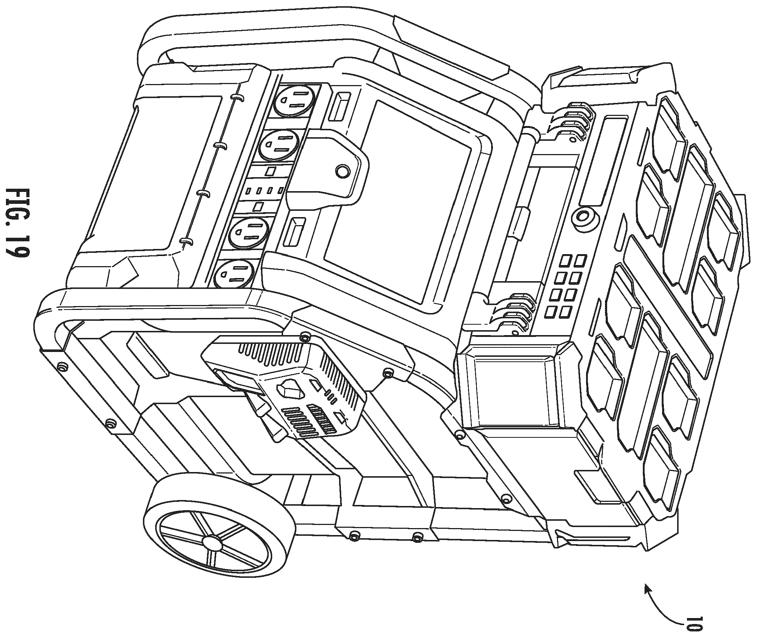

Turning to FIGS. 18 and 19 in particular, a bottom surface 82 of a modular storage unit, shown as modular tool storage unit 80, is shown coupled to the top of power unit 10. In a specific embodiment, modular system 6 includes power unit 10 and modular tool storage unit 80. In a specific embodiment, the modular storage unit includes coupling components that are compatible with the coupling mechanism(s) described in International Patent Application No. PCT/US2018/044629. In a specific embodiment, power supply unit system 84 includes modular tool storage unit 80 and power unit 10, with modular tool storage unit 80 coupled to a top of power unit 10, such as bottom surface 82 of modular tool storage unit 80 coupled to upper surface 12 of power unit 10.

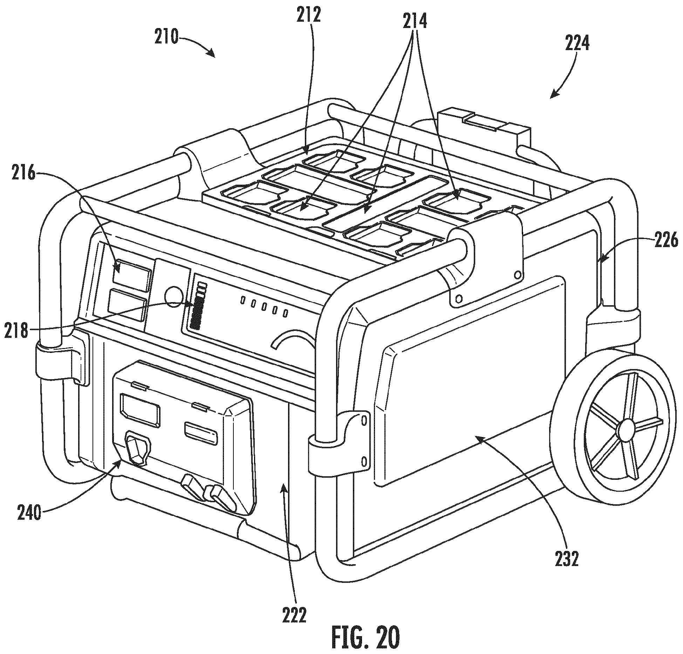

Turning to FIG. 20, various aspects of power unit 210 are shown. Power unit 210 is substantially the same as power unit 10 and power unit 110 except for the differences described herein. Power unit 210 includes charger 240 on a front surface of housing 232. Charger 240 is similar to charger 40, charger 42 and charger 44 except for the differences discussed herein. Upper surface 212 of housing 232 includes one or more coupling components 214.

In a specific embodiment, coupling components 214 are compatible with the coupling mechanism(s) described in International Patent Application No. PCT/US2018/044629. In a specific embodiment, a gripping device, shown as retractable handle 224, is coupled to rear surface 226 of housing 232.

In a specific embodiment, user interface 218 and charger 240 are mounted on the same surface 222 of housing 232. In another specific embodiment, power outlets 216 and charger 240 are mounted on the same surface 222 of housing 232. In another specific embodiment, user interface 218, power outlets 216 and charger 240 are all mounted on the same surface 222 of housing 232. In specific embodiments as shown in FIG. 20, surface 222 is front surface of housing 232 and is located opposite from the rear wheels and/or from retractable handle 224.

In a specific embodiment, at least one of power outlets 216 is an interface similar to a wall outlet. In a specific embodiment, at least one of power outlets 216 is a USB-compatible interface.

It should be understood that the figures illustrate the exemplary embodiments in detail, and it should be understood that the present application is not limited to the details or methodology set forth in the description or illustrated in the figures. It should also be understood that the terminology is for description purposes only and should not be regarded as limiting.

Further modifications and alternative embodiments of various aspects of the disclosure will be apparent to those skilled in the art in view of this description. Accordingly, this description is to be construed as illustrative only. The construction and arrangements, shown in the various exemplary embodiments, are illustrative only. Although only a few embodiments have been described in detail in this disclosure, many modifications are possible (e.g., variations in sizes, dimensions, structures, shapes and proportions of the various elements, values of parameters, mounting arrangements, use of materials, colors, orientations, etc.) without materially departing from the novel teachings and advantages of the subject matter described herein. Some elements shown as integrally formed may be constructed of multiple parts or elements, the position of elements may be reversed or otherwise varied, and the nature or number of discrete elements or positions may be altered or varied. The order or sequence of any process, logical algorithm, or method steps may be varied or re-sequenced according to alternative embodiments. Other substitutions, modifications, changes and omissions may also be made in the design, operating conditions and arrangement of the various exemplary embodiments without departing from the scope of the present disclosure.

Unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is in no way intended that any particular order be inferred. In addition, as used herein, the article "a" is intended to include one or more component or element, and is not intended to be construed as meaning only one. As used herein, "rigidly coupled" refers to two components being coupled in a manner such that the components move together in a fixed positional relationship when acted upon by a force.

Various embodiments of the disclosure relate to any combination of any of the features, and any such combination of features may be claimed in this or future applications. Any of the features, elements or components of any of the exemplary embodiments discussed above may be utilized alone or in combination with any of the features, elements or components of any of the other embodiments discussed above.

Aspects of the present disclosure may also be defined by the following clauses:
1. A power supply unit comprising:
   a housing;
   an upper surface of the housing;
   a first coupler located along the upper surface, the first coupler configured to couple the upper surface of the power supply unit to a bottom surface of a modular storage unit;
   a battery; and
   a power outlet in electrical communication with the battery.
2. The power supply unit of clause 1, comprising a storage compartment defined at least in part by the housing.
3. The power supply unit of clause 1, comprising a plurality of wheels rotatably coupled to the housing, and a handle coupled to the housing.
4. The power supply unit of clause 1, comprising a power tool battery charger detachably coupled to the power supply unit, the power tool battery charger electrically coupled to the battery.
5. The power supply unit of clause 4, comprising a display that indicates various aspects of the power supply unit.
6. The power supply unit of clause 1, comprising a handle rotatably coupled to the housing, the upper surface configured to receive the handle.
7. The power supply unit of clause 1, the power outlet configured to provide alternating current (AC) electricity, the power supply unit comprising a second power outlet configured to provide direct current (DC) electricity.
8. The power supply unit of clause 7, wherein the second power outlet is a USB-compatible outlet.
9. A power supply unit comprising:
   a housing;
   an upper surface of the housing;
   a first interface located along the upper surface, the first interface configured to couple the upper surface of the power supply unit to a bottom surface of a modular storage unit;
   a first power outlet configured to provide alternating current (AC) electricity; and
   a second power outlet configured to provide direct current (DC) electricity.
10. The power supply unit of clause 9, comprising a storage compartment defined at least in part by the housing.
11. The power supply unit of clause 9, comprising a power tool battery charger detachably coupled to the power supply unit, the power tool battery charger electrically coupled to the battery.
12. The power supply unit of clause 11, comprising a display that indicates various aspects of the power supply unit.
13. The power supply unit of clause 9, comprising a battery.
14. The power supply unit of clause 9, wherein the second power outlet is a USB-compatible outlet.
15. The power supply unit of clause 9, comprising a handle rotatably coupled to the housing, the upper surface configured to receive the handle.
16. A power supply unit assembly comprising:
   a power supply unit comprising:
      a housing;
      an upper surface of the housing;
      a battery;
      a plurality of coupling components located along the upper surface, the plurality of coupling components configured to couple the upper surface of the power supply unit to a bottom surface of a modular storage unit; and
      a mount configured to couple to a power tool battery charger; and
   a power tool battery charger physically coupled to the mount and electrically coupled to the battery, the power tool battery charger comprising a docking station configured to physically couple to a power tool battery and provide electricity to the power tool battery from the battery.
17. The power supply unit of clause 16, comprising a first power outlet configured to provide alternating current (AC) electricity, and a second power outlet configured to provide direct current (DC) electricity, wherein the second power outlet is a USB-compatible outlet.
18. The power supply unit of clause 16, comprising a power outlet.
19. The power supply unit of clause 16, comprising a storage compartment defined at least in part by the housing.
20. The power supply unit of clause 16, comprising a plurality of wheels rotatably coupled to the housing, and a handle coupled to the housing.

## Claims

1. A power supply unit comprising:
a housing;
an upper surface of the housing;
a coupler located along the upper surface, the coupler configured to couple the upper surface to a bottom surface of a modular storage unit;
a battery;
a first power outlet in electrical communication with the battery and configured to provide power from the battery;
a second power outlet configured to provide direct current (DC) electricity from the battery; and
a display positioned on a front face of the housing, the display indicating information about an amount of power currently stored in the battery.

2. The power supply unit of claim 1, wherein the second power outlet is a USB-compatible outlet.

3. The power supply unit of claim 1 or 2, wherein the second power outlet is located on the front face.

4. The power supply unit of any preceding claim, wherein the display is located on a first region of the front face and wherein the second power outlet is located on a second region of the front face.

5. The power supply unit of any preceding claim, wherein the first power outlet is configured to provide alternating current (AC) electricity.

6. The power supply unit of any preceding claim, wherein the first power outlet is located on the front face.

7. The power supply unit of any preceding claim, wherein the display is located on a first region of the front face and wherein the first power outlet is located on a second region of the front face.

8. The power supply unit of claim 1, wherein the first power outlet is configured to provide alternating current (AC) electricity and is located on the front face, wherein the second power outlet is a USB-compatible outlet and is located on the front face, and wherein the first power outlet is positioned to a lateral side of the display on the front face.

9. The power supply unit of any preceding claim, wherein the display indicates an amount of power being output from the power supply unit.

10. The power supply unit of any preceding claim, wherein the display is recessed relative to a forward-most surface of the housing.

11. The power supply unit of any preceding claim, comprising a top panel that is coupled to the housing, the top panel comprising the coupler, wherein the top panel is pivotable with respect to the housing.

12. The power supply unit of claim 1, the coupler comprising a recessed surface and a rib extending over and above the recessed surface, the recessed surface and the rib configured to collectively receive a projection extending from the modular storage unit to thereby couple the modular storage unit to the coupler.

13. The power supply unit of any preceding claim, wherein the coupler is a female coupler, and the female coupler is configured to rigidly couple the upper surface to the bottom surface of the modular storage unit.
